# EUROPÄISCHE PATENTSCHRIFT

(11) **EP 0 419 934 B1**
(45) Veröffentlichungstag und Bekanntmachung des Hinweises auf die Patenterteilung: **29.06.1994**
(21) Anmeldenummer: 90117476.3
(22) Anmeldetag: 11.09.1990
(51) Int. Cl.: H05K 7/18

(54) **Blechschrank zur Aufnahme elektronischer Baugruppen**
Sheetmetal cabinet for electronic components assemblies
Armoire en tôle pour assemblages de composants électroniques

(30) Priorität: 28.09.1989 DE 3932488
(43) Veröffentlichungstag der Anmeldung: 03.04.1991
(73) Patentinhaber: SIEMENS AKTIENGESELLSCHAFT, 80333 München (DE)
(72) Erfinder: Störk, Peter, D-8196 Eurasburg (DE); Niggl, Heinz, D-8134 Pöcking (DE); Buchberger Georg, D-8000 München 71 (DE); Zell, Karl, D-8134 Niederpöcking (DE)

(56) Entgegenhaltungen:
- CH-A- 503 395
- FR-A- 2 571 582
- US-A- 2 959 715

## Beschreibung

Die vorliegende Patentanmeldung betrifft einen Blechschrank zur Aufnahme elektronischer Baugruppen. Die bisherigen Blechschränke zur Aufnahme elektronischer Baugruppen zeichnen sich in der Regel durch eine aufwendige Bauweise aus, die zu schweren und unhandlichen Schränken führte. Die einzelnen Schränke bestanden in der Regel aus einem Gestell, an welchem dann die Seitenwände sowie Boden-, Deckenteile und Rückwand als auch Tür aufwendig befestigt werden mußten. Besondere Schwierigkeiten ergaben sich, wenn eine hundertprozentige Abschirmung des Schrankes erreicht werden sollte.

Ein weiterer Nachteil der bisherigen Schränke ist ihr hohes Gewicht und ihr aufwendiger Zusammenbau. Als zusätzlicher Nachteil kommt hinzu, daß die Schränke vorgegebene Größen hatten und der Kunde sich bei der Bestellung für eine bestimmte Grössenordnung entscheiden mußte.

Aufgabe der vorliegenden Erfindung ist es, einen Blechschrank anzugeben, welcher sich durch einen einfachen Aufbau, sowie geringes Gewicht auszeichnet und der auf einfache Weise erweiterbar sein soll.

Diese Aufgabe wird für einen Blechschrank zur Aufnahme elektronischer Baugruppen dadurch gelöst, daß Seitenwände, Boden- und Decke aus ebenen Blechzuschnitten geformt sind, deren mittlerer Bereich gelocht ist und deren Randbereiche parallele senkrecht zu den Rändern verlaufende Schlitze aufweisen, wobei die Randbereiche zur Bildung vorderer und hinterer Holme mit rechteckförmigen Querschnitten derart mehrfach abgewinkelt sind, daß die freien Ränder der Blechzuschnitte jeweils mit dem mittleren Bereich fest verbindbar sind, daß die Seitenwände mit Boden und Decke mittels einen quadratischen Querschnitt aufweisenden Verbindungselementen verbunden sind, und daß als Vorder- und Rückwand mit Schirmkontakten versehene gelochte Bleche aufsteckbar sind.

Der erfindungsgemäße Schrank zeichnet sich durch einen einfachen Aufbau aus. Er benötigt kein Rahmengestell, an welchem aufwendig die Seitenteile befestigt werden müssen. Ein weiterer Vorteil des erfindungsgemäßen Schrankes liegt darin, daß er billig in der Herstellung ist.

Eine vorteilhafte Ausgestaltung des erfindungsgemäßen Blechschrankes ist dadurch gekennzeichnet, daß die Vorder- und Rückwände so wie die Seitenwände vorgegebene Höhen aufweisen, wobei die Seitenwände über die Verbindungselemente miteinander verbindbar sind. Auf diese Art und Weise kann ein bestehender Schrank einfach ohne große Umbauten in der Höhe erweitert werden.

Eine andere vorteilhafte Ausgestaltung der Erfindung besteht darin, daß die Vorderwände mittels Scharniere mit einem vorderen seitlichen Holm verbunden sind, so daß die Vorderwände sich wie eine normale Schranktür bewegen lassen. Eine weitere zweckmäßige Ausgestaltung der Erfindung besteht darin, daß die in den Randbereichen der Blechzuschnitte verlaufenden Schlitze in der Mitte erweitert sind. Auf diese Weise werden an den vorderen und rückwärtigen Kanten des Schrankes Schlitze zur Durchführung der an- sowie abgehenden Kabel geschaffen. Weiterhin kann es unter Umständen von Vorteil sein, die Vorderwand aus einem glatten Blechteil auszubilden.

Eine andere zweckmäßige Ausgestaltung des erfindungsgemäßen Blechschrankes besteht darin, daß auf die Seitenwände und die Decke Designteile aufsteckbar sind.

Nachfolgend wird die Erfindung an einem in der Zeichnung dargestellten Ausführungsbeispiel näher erläutert.

Es zeigen:
- FIG 1: eine perspektifische Teilansicht eines Blechschrankes gemäß der vorliegenden Erfindung, und
- FIG 2: einen Schnitt durch einen senkrechten Holm des erfindungsgemäßen Blechschrankes.

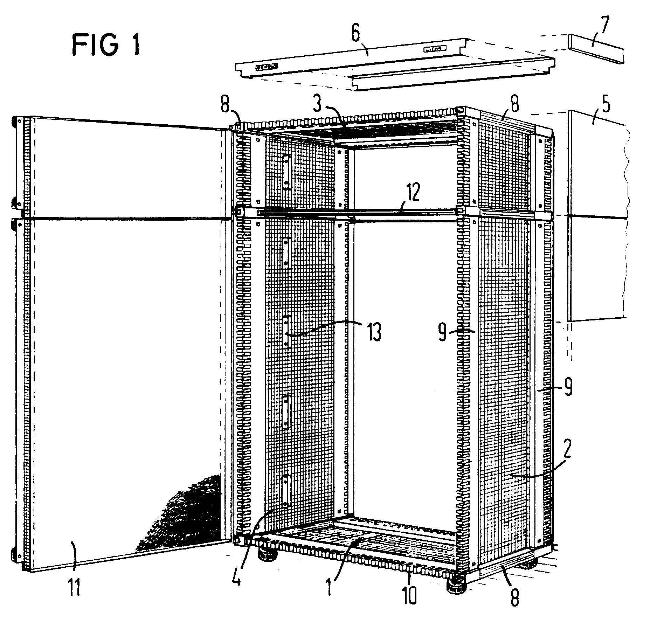

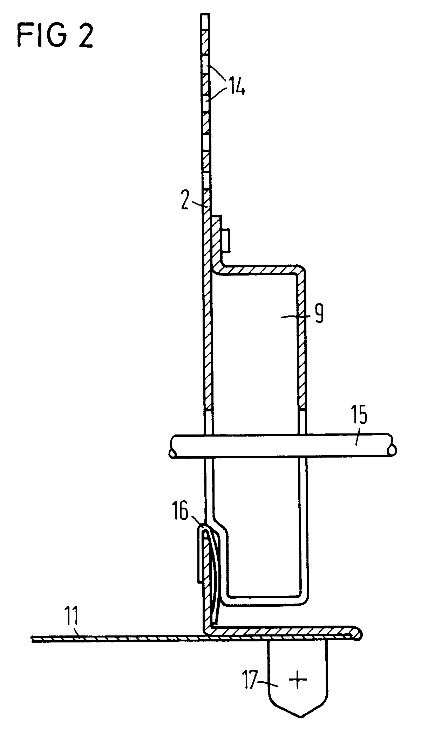

Die wesentlichen Bauelemente des in der FIG 1 dargestellten erfindungsgemäßen Blechschrankes sind die Seitenwände 2 und 4 sowie der Boden 1 und die Decke 3. Diese Teile sind aus ebenen Blechzuschnitten geformt, deren mittlerer Bereich gelocht ist und deren Randbereiche parallele senkrecht zu den Rändern verlaufende Schlitze aufweisen. Dabei sind die Randbereiche derart mehrfach abgewinkelt, wie aus FIG 2 zu ersehen ist, daß die freien Ränder der Blechzuschnitte jeweils mit dem mittleren Bereich fest verbunden sind. Auf diese Weise bilden die Randbereiche der Blechzuschnitte die tragenden Holme des Blechschrankes 1, welche diesem die notwendige Stabilität verleihen.

Seitenwände, Boden und Decke sind mittels Verbindungselementen 8 miteinander verbunden, welche einen quadratischen Querschnitt aufweisen. Auf diese Weise ergibt sich eine einfache Konstruktion des Blechschrankes. Die Löcher der Blechzuschnitte werden als Befestigungslöcher 14 zur Befestigung von Befestigungselementen 13 verwendet, an welche nicht dargestellte Baugruppen befestigt werden können.

Aufgrund der in den Holmen übereinander angeordneten Schlitze ist in allen Randbereichen an den Seiten sowie oben und unten eine Durchführung von ankommenden und abgehenden Kabeln bei geschlossenem Schrank möglich. Die Vorderwände 11 können als schwenkbare Tür mittels Scharniere 17 oder als aufsteckbare Blechwand ausgebildet sein, die mit Schirmkontakten 16 den Vorderteil des Blechschrankes HF - dicht abschließen.

Die Rückwand ist in FIG 1 nicht dargestellt, jedoch sollte diese aus gelochtem Blech bestehen, da sich dadurch eine günstige Wärmeableitung ergibt.

Ein weiterer Vorteil des erfindungsgemäßen Schrankes ergibt sich aus der Verwendung von Seiten- sowie Vorder- und Rückwänden unterschiedlicher Länge. Auf diese Weise ist - wie aus der FIG 1 ersichtlich - jederzeit eine gezielte Erweiterung des Blechschrankes möglich.

Sollte es gewünscht sein, so können die Seitenwände sowie die Decke des erfindungsgemäßen Blechschrankes mit Designteilen verkleidet werden, wobei die jeweilige Höhe der verwendeten Designteile für die Seitenteile der Höhe der verwendeten Seitenwände entspricht.

## Patentansprüche

1. Blechschrank zur Aufnahme elektronischer Baugruppen,
**dadurch gekennzeichnet**, daß Seitenwände (2, 4), Boden (1) und Decke (3) aus ebenen Blechzuschnitten geformt sind, deren mittlerer Bereich gelocht ist und deren Randbereiche parallele senkrecht zu den Rändern verlaufende Schlitze (18) aufweisen, wobei die Randbereiche zur Bildung vorderer und hinterer Holme mit rechteckförmigen Querschnitten derart mehrfach abgewinkelt sind, daß die freien Ränder der Blechzuschnitte jeweils mit dem mittleren Bereich fest verbindbar sind, daß die Seitenwände (2, 4) mit Boden (1) und Decke (3) mittels einen quadratischen Querschnitt aufweisenden Verbindungselementen (8) verbunden sind, und daß als Vorder- und Rückwand mit Schirmkontakten (16) versehene gelochte Bleche (11) aufsteckbar sind.

2. Blechschrank nach Anspruch 1,
**dadurch gekennzeichnet**, daß die Vorder- und Rückwände sowie die Seitenwände (2, 4) vorgegebene Höhen aufweisen, wobei die Seitenwände (2, 4) über die Verbindungselemente (8) miteinander verbindbar sind.

3. Blechschrank nach Anspruch 1,
**dadurch gekennzeichnet**, daß die Vorderwände (11) mittels Scharniere (17) mit einem vorderen seitlichen Holm (9) verbunden sind.

4. Blechschrank nach einem der vorhergehenden Ansprüche,
**dadurch gekennzeichnet**, daß die in den Randbereichen der Blechzuschnitte verlaufenden Schlitze (18) in der Mitte erweitert sind.

5. Blechschrank nach Anspruch 1,
**dadurch gekennzeichnet**, daß die Vorderwand aus einem glatten Blechteil gebildet ist.

6. Blechschrank nach Anspruch 5,
**dadurch gekennzeichnet**, daß auf Seitenwände (2, 4) und Decke (3) Designteile (5 bis 7) aufsteckbar sind.

## Claims

1. Sheet-metal cabinet for accommodating electronic assemblies, characterized in that side panels (2, 4), a bottom panel (1) and a top panel (3) are formed from flat sheet-metal blanks whose central region is perforated and whose edge regions have parallel slots (18) running at right angles to the edges, the edge regions being bent a plurality of times in order to form front and rear struts having rectangular cross-sections, in such a manner that the free edges of the sheet-metal blanks can in each case be firmly connected to the central region, in such a manner that the side panels (2, 4) are connected to the bottom panel (1) and top panel (3) by means of connecting elements (8) which have a square cross-section, and in such a manner that perforated metal sheets (11), which are provided with screen contacts (16) can be plugged on as a front panel and rear panel.

2. Sheet-metal cabinet according to Claim 1, characterized in that the front and rear panels as well as the side panels (2, 4) have predetermined heights, it being possible to connect the side panels (2, 4) to one another via the connecting elements (8).

3. Sheet-metal cabinet according to Claim 1, characterized in that the front panels (11) are connected to a front side strut (9) by means of hinges (17).

4. Sheet-metal cabinet according to one of the preceding claims, characterized in that the slots (18) which run in the end regions of the sheet-metal blanks are expanded in the centre.

5. Sheet-metal cabinet according to Claim 1, characterized in that the front panel is formed from a smooth sheet-metal part.

6. Sheet-metal cabinet according to Claim 5, characterized in that design parts (5 to 7) can be plugged onto the side panels (2, 4) and top panel (3).

## Revendications

1. Armoire en tôle destinée à loger des ensembles électroniques, caractérisée en ce qu'à partir de morceaux de tôle plans découpés sont réalisées des parois latérales (2, 4), un fond (1) et un plafond (3), dont la zone médiane comporte des trous et dont les zones marginales présentent des fentes (18) s'étendant parallèlement aux bords, les zones marginales étant coudées plusieurs fois à angle droit en vue de réaliser des montants avant et arrière de section transversale rectangulaire, de façon telle que les bords libres des morceaux de tôle découpés puissent chacun être solidement fixés aux zones médianes, en ce que les parois latérales (2, 4) sont reliées au fond (1) et au plafond (3) au moyen d'éléments de liaison (8) de section transversale carrée et en ce que des tôles perforées (11) munies de contacts (16) de blindage peuvent y être enfichées pour servir de paroi avant et de paroi arrière.

2. Armoire en tôle selon la revendication 1, caractérisée en ce que les parois avant et arrière, ainsi que les parois latérales (2, 4) ont des hauteurs fixées à l'avance, les parois latérales (2, 4) pouvant être reliées entre elles par des éléments de liaison (8).

3. Armoire en tôle selon la revendication 1, caractérisée en ce que les parois avant (11) sont reliées par des charnières (17) à un montant latéral avant (9).

4. Armoire en tôle selon l'une des revendications précédentes, caractérisée en ce que les fentes (18) qui s'étendent dans les zones marginales des morceaux de tôle découpés sont élargies en leur milieu.

5. Armoire en tôle selon la revendication 1, caractérisée en ce que la paroi avant est constituée par une pièce de tôle lisse.

6. Armoire en tôle selon la revendication 5, caractérisée en ce que des pièces décoratives (5 à 7) peuvent être enfilées sur les parois latérales (2, 4) et sur le plafond (3).
